# Europäisches Patentamt

# European Patent Office

# Office européen des brevets

(11) Publication number: **0 087 253**
**B1**

(12) **EUROPEAN PATENT SPECIFICATION**

(45) Date of publication of patent specification: **27.08.86**

(51) Int. Cl.⁴: **H 01 S 3/19**

(21) Application number: **83300717.2**

(22) Date of filing: **14.02.83**

(54) Improvements in or relating to semi-conductor lasers.

(30) Priority: **24.02.82 GB 8205445**

(43) Date of publication of application:
**31.08.83 Bulletin 83/35**

(45) Publication of the grant of the patent:
**27.08.86 Bulletin 86/35**

(84) Designated Contracting States:
**BE CH DE FR IT LI NL SE**

(56) References cited:
**EP-A-0 039 886**
**DE-A-3 036 431**
**GB-A-1 564 908**

**IOOC1981, THIRD INTERNATIONAL CONFERENCE ON INTEGRATED OPTICS AND OPTICAL FIBER COMMUNICATION, San Francisco, CA., USA, 27th-29th April 1981, pages 54-55, New York, USA R.C.**

**GOODFELLOW et al.: "Buried heterostructure 1.3-mum lasers with multiple layer infill"**

**ELECTRONICS LETTERS, vol. 17, no. 21, October 1981, pages 782-783, London GB. Y. NAKANO et al.: "High power output InGaAsP/InP buried heterostructure lasers"**

(73) Proprietor: **PLESSEY OVERSEAS LIMITED**
**Vicarage Lane**
**Ilford Essex IGI 4AQ (GB)**

(72) Inventor: **Goodfellow, Robert Charles**
**1 Octavian Way**
**Brackley Northants (GB)**
Inventor: **Harding, Malcolm Edward**
**7 Hale Avenue**
**Stony Stratford (GB)**

(74) Representative: **Goodman, Christopher**
**The Plessey Company plc**
**Beeston Nottingham NG9 1LA (GB)**

(56) References cited:

**ELECTRONICS LETTERS, vol. 18, no. 6, 18th March 1982, pages 262-263, London, GB. R. PLASTOW et al.: "Low-threshold current CW operation of multiple infil buried heterostructure 1.3 mum GaInAsP lasers"**

Courier Press, Leamington Spa, England.

## Description

### Technical Field

This invention relates to semi-conductor lasers of the type comprising a plurality of expitaxial layers and a buried active laser layer in order to obtain light and carrier confinement in the active laser layer.

### Background Art

Such a semi-conductor laser is described in United Kingdom Patent GB—A—1564908, but a problem with this type of laser is current leakage around the sides of the active laser stripe. As the width of the stripe is reduced the operating current reduces, but the current leakage remains unchanged. The leakage may thus dominate the current of narrow stripe lasers.

One method of inhibiting this leakage is to provide an infill each side of the active strip consisting of a p-type material followed by an n-type material which introduces a reverse biassed junction and so substantially prevents current flow. The junction should terminate in line with the active stripe but if the junction is out of line with the stripe, current will leak either from p-type layer above the active stripe through the p-type infill, or there will be a direct current path from the infill to the n-type body. The use of a single reversed biassed junction thus necessitates extreme accuracy of location of the junction.

### Disclosure of the Invention

The present invention is intended to provide means for preventing current leakage around the sides of the active laser stripe which does not require such high degree of accuracy.

According to the present invention there is provided a semi-conductor laser comprising: a layer of n-type material; a layer of p-type material; an active laser stripe located between the n-type and p-type layers; and a multiplicity of thin infill layers lying adjacent each side of the active laser stripe and at least a portion of each of the n-type and p-type layers; the infill layers having a doping sequence such that a multiplicity of p-n junctions are defined at interfaces between the infill layers; characterised in that the infill layers are substantially planar being such that the ends thereof abut the sides of the n-type layer, the laser stripe, and the p-type layer.

In the preferred construction of this invention discussed below, a plurality of the infill layers are located below the level of the laser stripe and provide therefore at least one reverse-biased p-n junction lying below the stripe.

### Brief Introduction of the Drawings

In the accompanying drawings:

Figure 1 shows in schematic form a known design of semiconductor laser;

Figures 2 and 3 are scrap cross-sectional views of the semiconductor laser shown in Figure 1;

Figure 4 illustrates in schematic form another known semi-conductor laser, one having a large number of infill layers; and,

Figure 5 illustrates an example of a semi-conductor laser constructed in accordance with this invention.

### Description of the Preferred Embodiment

An embodiment of the invention will be described herein below, with reference to the drawings.

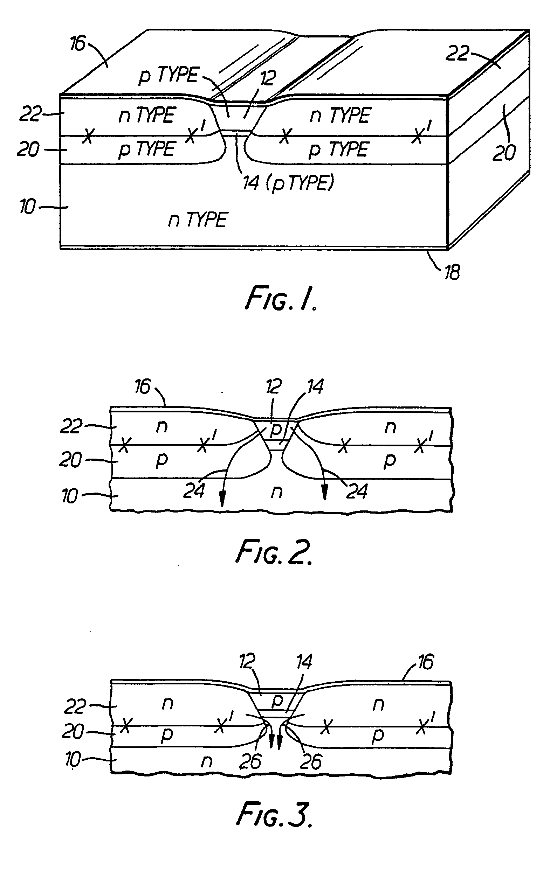

In Figure 1 is illustrated a known type of buried heterostructure laser comprising an indium phosphide substrate 10 of n-type conductivity and an indium phosphide layer 12 of p-type conductivity.

A gallium indium arsenide phosphide active laser stripe 14 of elongate shape of a p-type conductivity is located between the substrate 10 and the layer 12 and forms a reverse biassed p-n junction between it and the substrate 10. The free ends of the laser stripe 14 emerge at separate surfaces of the indium phosphide body. Abutting the sides of the laser stripe 14 is an infill comprising a layer 20 of p-type indium phosphide followed by a layer 22 of n-type indium phosphide which introduces a reverse biassed junction $XX^1$ and substantially prevents current leakage from the layer 12 around the sides of the laser stripe 14.

A metal contact 16 is formed on the layers 12 and 22 covering the whole surface of the structure and a further metal contact 18 is secured to the base of the structure.

The junction $XX^1$ should terminate on the side of the laser stripe 14 for minimum current leakage.

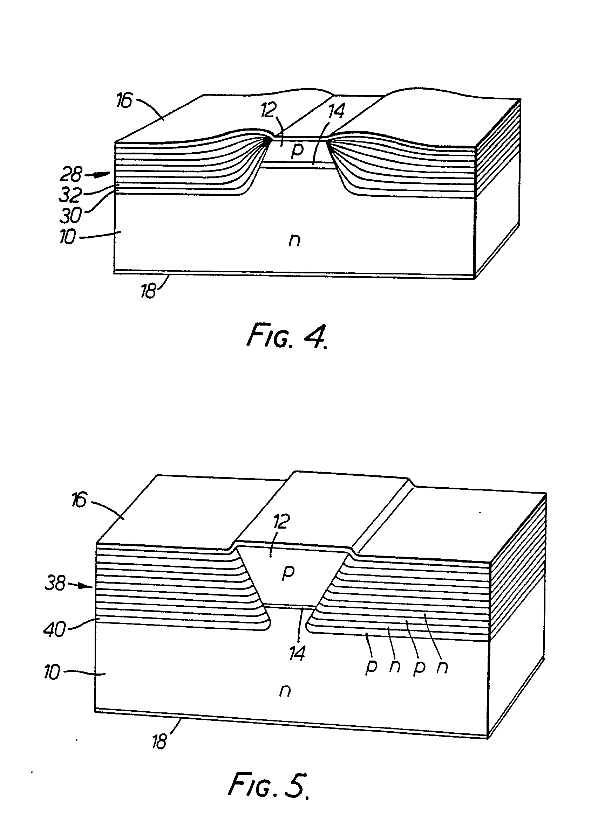

However, if the line $XX^1$ terminates slightly above the active stripe 14 (which is normally very thin, of the order of 0.2 μm) as illustrated in Figure 2, current can leak along the lines of the arrows 24. Alternatively if the line $XX^1$ terminates below the active stripe 14 as shown in Figure 3 there will be a direct current (short circuit) path along the lines of the arrows 26. Thus with the single junction approach it is necessary to control the reverse bias junction position to extremely high accuracy.

Figure 4 shows a semi-conductor laser in which the two infill layers 20 and 22 are replaced by a large number of very thin layers 28 with a doping sequence such that a large number of p-n junctions are laid down. The doping sequence is n, i (intrinsic), p, n, i, p . . . etc.

A n-type layer 30 is deposited first and covers the substrate 10 and the sides of the laser stripe 14 and the p-type layer 12. The following layer 32 is formed so as to completely cover the layer 30 and subsequent layers all completely cover the preceding layer.

Further details of this design of laser were given at the IOOC 1981, Third International Conference on Integrated Optics and Optical Fibre Communications, San Francisco, CA, USA, 27th—29th April 1981, pages 54—55, New York, USA, in an article entitled "Buried heterostruc-

ture 1.3 μm lasers with multiple layer infill'' by R. C. Goodfellow et al.

In Figure 5 there is shown a semi-conductor laser having a large number of very thin layers 38 with a doping sequence such that a large number of p-n junctions are laid down. The doping sequence shown in p and n alternately.

The first layer 40 is substantially planar and does not cover the sides of the laser stripe 14 and the p-type layer 12. Subsequent layers are similar resulting in the ends of the layers 38 abutting the sides of the raised part of the substrate 10, the laser stripe 14 and the p-type layer 12. In this case the active stripe 14 is located between a layer 10 and a layer 12 which together have an inverted trapezoidal cross-sectional shape and the use of the large number of separate layers achieves good electrical isolation in mesa structure where growth on the walls of the layer 12 and the raised portion of the substrate 10 is sufficiently slow to permit ''stacking'' of the layers 38. This is the case with re-entrant mesas in InP having (111) A faces.

The advantages here are that all the possible leakage paths involve conduction along very thin layers and hence are significantly more resistive than the structures described and illustrated in Figures 1 to 3. Also most paths involve conduction through numbers of forward and reverse biassed p-n junctions in series. At least one reverse biassed p-n junction lies below the level of the laser strip 14. This results in the significant reduction in the current leakage at the sides of the active region.

The method may be extended so that the sequence of infill layers 38 includes wide band-gap materials and therefore heterojunctions which will have a higher breakdown voltage and perhaps lower conductivity because of different transport properties.

The method of using a large number of very thin layers with a large number of p-n junctions may also be used where high pressure resistance groups III—V semiconductor layers are required.

By including narrow band-gap layers into the multi-layer infill 28, regions of high refractive index can be introduced at the sides of the active region. This will be equivalent to decreasing the refractive index step at the edge of the active stripe 14. This will allow single transverse mode operation in wider stripes and could therefore offer increased single mode power capability in such lasers.

## Claims

1. A semiconductor laser comprising: a layer of n-type material (10); a layer of p-type material (12); an active laser stripe (14) located betwen the n-type and p-type layers (10 and 12); and, a multiplicity of thin infill layers (38) lying adjacent each side of the active laser stripe (14) and at least a portion of each of the n-type and p-type layers (10 and 12); the infill layers (38) having a doping sequence such that a multiplicity of p-n junctions are defined at interfaces between the infill layers (38); characterised in that the infill layers (38) are substantially planar such that the ends thereof abut the sides of the n-type layer (10), the laser stripe (14), and the p-type layer (12).

2. A semiconductor laser, as claimed in claim 1, wherein a plurality of the infill layers (38) are located below the level of the laser stripe (14) therby providing at least one reverse biassed p-n junction below this level.

3. A semiconductor laser, as claimed in either one of claims 1 or 2, wherin the p-type layer (12), the laser stripe (14), and a projecting portion of the n-type layer (10) together provide a mesa of inverted trapezoidal cross-section.

4. A semiconductor laser, as claimed in any one of the preceding claims, where the infill layers (38) are doped p-type and n-type alternately in sequence.

5. A semiconductor laser, as claimed in any one of the preceding claims, where a metal contact (16) is formed on the multiplicity of infill layers (38) and the p-type material (12), and, a further metal contact is formed on the n-type material (10).

6. A semiconductor laser, as claimed in any one of the preceding claims, where the active laser stripe (14) comprises gallium indium arsenide phosphide, and the layers of n-type material (10) and p-type material (12) comprise indium phosphide.

7. A semiconductor laser, as claimed in any one of the preceding claims, where the plurality of infill layers (38) comprise indium phosphide.

8. A semiconductor laser, as claimed in any one of the preceding claims 1 to 6, wherein the infill layers (38) include layers of wide band-gap material and provide thereby a multiplicity of hereojunctions having high breakdown voltage characteristics.

9. A semiconductor laser, as claimed in any one of the preceding claims 1 to 6, wherein the infill layers (38) include layers of narrow band-gap high refractive index material.

## Patentansprüche

1. Ein Halbleiterlaser, bestehend aus: einer Schicht von n-artigem Material (10); einer Schicht von p-artigem Material (12); einem aktiven Laserstreifen (14) zwischen den n-artigen und den p-artigen Schichten (10 und 12); und einer Veilzahl von Füllschichten (38), die neben jeder Seite des aktiven Laserstreifens (14) und mindestens eines Teils jeder der n-artigen und p-artigen Schichten (10 und 12) liegen, wobei die Füllschichten (38) eine derartige Dotierungsfolge haben, daß eine Veilzhal von p-n-Übergägen an Schnittstellen zwischen den Füllschichten (38) definiert werden; dadurch gekennzeichnet, daß die Füllschichten (38) im wesentelichen planar sind, so daß deren Enden an die Seiten der n-artien Schicht (10), des Laserstreifens (14) und der p-artigen Schicht (12) anstoßen.

2. Ein Halbleiterlaser gemäß Anspruch 1, in dem eine Vielzahl der Füllschichten (38) unter dem Niveau des Laserstreifens (14) liegen, wodurch mindestens ein Sperr-Vorspannungs-pn-Übergang unterhalb dieses Niveaus gewährt wird.

3. Ein Halbleiterlaser gemäß Anspruch 1 oder 2, in dem die p-artige Schicht (12), der Laserstreifen (14) un ein herausragender Teil der n-artigen Schicht (10) zusammen einen Mesa von invertiertem trapezförmigen Querschnitt gewähren.

4. Ein Halbleiterlaser gemäß irgendeinem der voraufgegangenen Ansprüche, in welchem die Flüllschichten (38) in abwechselnder Folge p-artig und n-artige dotiert sind.

5. Ein Halbleiterlaser gemäß irgendeinem der voraufgegangenen Ansprüche, in welchem ein Metallkontakt (16) auf der Vielzahl der Füllschichten (38) und dem p-artigen Material (12) gebildet wird und ein weiterer Metallkontakt auf dem n-artigen Material (10) gebildet wird.

6. Ein Halbleiterlaser gemäß irgendeinem der voraufgegangenen Ansprüche, in dem der aktive Laserstreifen (14) aus Gallium-Indium-Arsenid-Phosphid besteht und die Schichten des n-artigen Materials (10) und des p-artigen Materials (12) aus Indium-Phosphid bestehen.

7. Ein Halbleiterlaser gemäß irgendeinem der voraufgegangenen Ansprüche, in welchem die Vielzahl der Füllschichten (38) aus Indium-Phosphid besteht.

8. Ein Halbleiterlaser gemäß irgendeinem der voraufgegangenen Ansprüche, 1 bis 6, in welchem die Füllschichten (38) Schichten von Breitband-Lückenfüllmaterial einbeziehen und dadurch eine Vielfalt von Heteroüberängen bieten, die hohe Durchbruchspannungskennlinien haben.

9. Ein Halbleiterlaser gemäß irgendeinem der voraufgegangenen Ansprüche 1 bis 6, in welchem die Füllschichten (38) Schichten von Schmalband-Lückenfüllmaterial mit hohem Brechungsindex einbeziehen.

**Revendications**

1. Laser semi-conducteur comportant: une couche de matière modèle n (10); une couche de matière modèle p (12); une bande active de laser (14) située entre les couches modèles n et p (10 et 12); et, une série de couches intercalaires (38) situées de chaque côté de la bande active de laser (14) et au moins une portion de chacune des couches de matière n et p (10 et 12); les couches intercalaires (38) ayant une séquence de dopage telle qu'une série de liaisons p-n est définie aux interfaces entre les couches intercalaires (38); caractérisé en ce que les couches intercalaires (38) sont essentiellement planes étant telles que leurs extrêmités viennent en bout contre les côtés de couche modèle n (10), la bande laser (14) et la couche modèle p (12).

2. Un laser semi-conducteur selon la lère revendication, dans lequel plusieurs couches intercalaires (38) sont situées sous le niveau de la bande laser (14) assurant ainsi au moins une liaison p-n à polarité inverse sous ce niveau.

3. Un laser semi-conducteur selon l'une ou l'ature de la lère ou 2 ème revendication, dans lequel la couche modèle p (12), la band laser (14) et une portion en saillie de couche modèle n (14) assurant ensemble une mesa de coupe trapézoïdale inverse.

4. Un laser semi-conducteur selon l'une ou l'autre des revendications ci-avant, dans lequel les couches intercalaires (18) sont dopées en série alternante de modèle-p et modèle-n.

5. Un laser semi-conducteur selon l'une ou l'autre des revendications ci-avant, dans lequel un contact métallique (16) est formé sur la série de couches intercalaires (38) et la matière modèle-p, et un autre contact métallique est formé sur la matière modèle n (10).

6. Un laser semi-conducteur selon l'une ou l'autre des revendications ci-avant, selon lequel la bande active laser (14) comporte le phosphure arsenure de gallium-indium et les couches de matière modèle n (10) et modèle p (12) comporte le phosphure d'indium.

7. Un laser semi-conducteur selon l'une ou l'autre des revendications ci-avant, selon lequel la série de couches intercalaires (38) comporte le phosphure d'indium.

8. Un laser semi-conducteur selon l'une ou l'autre de la lère à la 6ème revendication, selon lequel les couches intercalaires (38) comportent des couches de matière à large entrefer de bande assurant ainsi une multiplicité d'hétéro-liaisons de haut pouvoir de coupure sous tension.

9. Un laser semi-conducteur selon l'une ou l'autre de la lère la 6ème revendication, selon lequel les couches intecalaires (38) comportent des couches de matière à faible entrefer de bande et à indice de réfraction élevé.

16

p TYPE

12

22

22

n TYPE

n TYPE

X X'

X X'

20

p TYPE

p TYPE

20

14 (p TYPE)

10

n TYPE

18

*Fig. 1.*

16

12 14

22

n

n

X X'

X X'

20

p

p

10

24

n

24

*Fig. 2.*

12 14 16

22

n

n

p

20

X X'

X X'

p

10

n 26

26

*Fig. 3.*

FIG. 4.

FIG. 5.